# EUROPEAN PATENT APPLICATION

(11) **EP 4 002 910 A1**
(43) Date of publication of application: **25.05.2022**
(21) Application number: 21206251.7
(22) Date of filing: 03.11.2021
(51) Int. Cl.: H04W 24/02, G01R 29/08

(54) **SYSTEM FOR DETECTING FREE FREQUENCIES ON GEOGRAPHIC AREAS BY MEANS OF SPECTRUM ANALYZERS**

(30) Priority: 24.11.2020 IT 202000028124
(71) Applicant: Ser.I.Tel. (Servizi Ed Impianti Per Telecomunicazioni) S.r.l., 80129 Napoli, (NA) (IT)
(72) Inventor: CORUZZOLO, Alessandro, 80129 Napoli (NA) (IT)
(74) Representative: Fiammenghi, Eva

(57) **Abstract**

System for detecting free frequencies on geographic areas by means of spectrum analyzers characterized in that it comprises a plurality of radiofrequency signal analyzers (100) which, by means of the use of GPS (104) and of a GSM connection (102), communicates the result of the spectral analysis to a central computer (103) placed within an operations center (107) where an operator reconstructs, by means of software application, the area covered for a given band, giving indications to the operators who use the analyzers regarding where to move in order to increase the measurement area and improve the measurements themselves.

## Description

### Field of the art

The present invention has application in the field of radio broadcast telecommunications with frequency modulation, more particularly it makes reference to a system dedicated to the acquisition and to the processing of the data for a use of the spectrum analyzer in monitoring the transmission performances of the radio broadcasting stations located in a given territorial area.

### Prior art

Spectrum analyzers are quite versatile instruments, widely used in measurements of amplitude and frequency modulation. In particular their use is essential in the detection of the transmission parameters of the electromagnetic fields in the radio-television transmissions of broadcast type.

As is known, a spectrum analyzer can evaluate - in a FM transmission - the frequency and the amplitude of the primary signal, and it is possible to directly observe the products of the distortion, the lateral bands of the frequency modulation and the frequency conversions. The Fourier analysis has a primary objective: given a periodic signal, be able to decompose it as a sum (overlap) of signals of sinusoidal type, each with its own frequency (integer multiple of a base frequency) and its own amplitude.

The passage from the description of a signal (intended as a periodic phenomenon) - from the standpoint of its time progression to its description from the standpoint of the decomposition in a sum of harmonics - is often termed passage from the time domain to the frequency domain.

While the oscilloscope reproduces the waveform as it is physically present, the spectrum analyzer reports a series of pulses that represent the frequencies and the amplitudes of the fundamental frequency and of its harmonics. These are two completely different views, but which both serve to define all the parameters of the signal under examination.

It is well known that in the FM transmitting plants, the radio signals with frequency modulation are emitted in the band comprised between 87.5-108 MHz, and the output power of the transmitter is constant with the variation of the modulation; nominally the channels are spaced by 300 kHz - in accordance with current laws - while the band necessary for a stereo emission is 150 kHz. It is possible to find stations which transmit on frequencies that are spaced by only 100 kHz or even in ISO FX. In order to distinguish the adjacent signals, which must not differ for at least 200 kHz, it would be necessary to use an RBW of 10 kHz. In reality, the use of an RBW of 10 kHz, with a span of 1 MHz is optimal, and a detector set on MAXHOLD.

Up to now, the detection of the performances of a broadcasting station for a given radio is manually executed in the field by setting the analyzer with frequency for example at 98.5 MHz and the span at IMhz, after the trace requiring the Maxhold has been set, then the image is saved in the analyzer, and then the relative information is saved on the PC. This is in any case a single measurement.

In order to execute at least 100 measurements, a great many hours are necessary, in practice, for at least a day, the operator is engaged for such type of detection and acquisition, which operates on each single work frequency.

Another problem which has appeared in the past was the time necessary to execute the search for a free resource, for example for making a new plant for municipal information with a new Radio xy. Up to now, one proceeded by circumscribing an area and configuring a polygon, then the measurement points are selected and the detections are executed. The subsequent delayed processing provides for downloading the single separate detections, and the overlap of all the traces in a single screen. In this delayed manner one is able to know if a data frequency is free in all points. This requires a delayed review activity, lacking the possibility to operate directly in the field. In addition, one proceeds by seeking the free frequency one at a time. Instead, if one had all the spectra available, in a summary representation, by superimposing them and analyzing the figure resulting from the summation, it would be possible to have an indication on where there is a free frequency dedicated to the new plant. It should be underlined herein that in the past, disadvantageously only single measurements were executed, broadcasting station by broadcasting station, so to execute a measurement campaign over the entire FM band, and this required at least a day. Indeed, each measurement required a precise sequence of steps: one physically accessed the site with the service vehicle - possibly screened -, one lifted the telescopic pole to ten meters, assembled the antenna and executed the detections; then, one moved to another station and repeated the measurement. One clearly sees the poor effectiveness of a monitoring broadcasting station-by-broadcasting station, in each site, separately.

The object of the present invention is that of exceeding - in a radical manner - the limitations of the present techniques, relative to the acquisition and to the processing of the data with the use of the spectrum analyzer for monitoring the transmission performances of the radio broadcasting stations located in a given territorial area. Another object of the present invention is that of providing a method and an architecture of the components for acquisition, processing and display of RF measurements, which uses detection protocols and analysis and processing means, for the acquired data, from among the most diffused and recognized as standards in the field of radio telecommunications, so as to render the attainment of the finding immediate, reliable and requiring easy management and maintenance.

The patent US2002190725A1 proposes a portable system adapted to act as a spectrum analyzer in a range of frequency bands. However, this invention does not at all describe an architecture that allows effectively using the spectrum analyzer for resolving the above-described problems.

The patent US2019162764A1 regards an extensive graphical display for displaying the results of a spectrum analyzer. However, the present invention discusses how to integrate information deriving from a plurality of analyzers, this characteristic being only one of the aspects of the idea described hereinbelow. Analogous considerations hold true for the patent US2019162764A1 which does not at all describe a possible network architecture for obtaining information on the signal in a geographic area.

Hence, there is no doubt that the abovementioned solutions only partly confront the critical features that were described above.

### Description of the invention

According to the present invention, system is attained for detecting free frequencies on geographic areas by means of spectrum analyzers, which effectively resolves the abovementioned problems.

The embodiment of the invention provides for the presence of an RF signal acquisition unit, an instrumentation for detecting the spectral components and a system for processing the information. Also provided for are memory units and a data processor that comprises them.

In the present invention, however, it is not proposed to make a substantial variation of the hardware or of the methodology that composes a classic spectrum analyzer; rather, one assumes a structure that integrates additional components that are connected according to the architecture ideated herein, allowing the resolution of the problem of the long time that is required, by simply using a prepackaged series of spectrum analyzers delivered to multiple operators.

In order to attain the proposed architecture, a base element consists of the presence of an operator in an operations center who views in real time, or in any case in very brief times, the result of the analysis of a collection of spectrum analyzers which are managed by other operators who, on the contrary, are situated in the field.

Before describing the tasks performed by said operations center, it is desired to describe which instruments are planned for the operators in the field. As mentioned above in the description of the state of the art, one problem which causes the elongation of the analysis times consists of the calculation and of the analysis to be carried out delayed. In order to solve this problem, it is proposed herein to equip the spectrum analyzers with additional hardware so as to render the instrument complete and autonomous for the application for searching for a free radio band. This hardware consists of a GPS module and of a GSM module for the connection to Internet network by means of antenna. In this manner, the results calculated by the spectrum analyzer can be sent as soon as ready directly to said operations center together with the position detected at the time of signal measurement.

First however it is desired to describe the mode in which the specific components of the spectrum analyzer will be used and how this instrument is adapted for the need that one wishes to satisfy by means of the idea described herein.

The spectrum analyzer provided for in the present invention is of the type produced by known manufacturers in the field of instrumentation for electronic measurements, without there being requested particular types of performances for this, in the base variant of this idea, if not those basic performances for an instrument of this type. Various types of antennas can be used, from integrated antennas to external antennas with greater size. The antenna type is actually dependent on the way in which one wishes to apply the present invention in practice.

One variation that shall be introduced herein regards the mode of use. Essentially, one operates an automatic frequency scanning with pre-established parameters. Instead, in the past, these measurements were manually executed, in the field, one by one. For example, one initialized the analyzer with a data frequency at 98.5 MHz and the span at 1Mhz, after which one set the trace by requesting the Maxhold, then one saved the image in the analyzer, and finally one downloaded the same on the PC; but in any case, this was a single detection, a single measurement and a single storage. In reality, from 87.5Mhz to 108 Mhz there are at least 100 measurements to be executed, and a great many hours would be necessary to execute all of them. With the application according to the present invention, a time on the order of about 3 minutes is necessary, in the case of a single computing process and single antenna, for its acquisition regardless of the actual final phase.

One of the assumptions that we initially establish is that - given a band setting and a measurement of the radial signal for such band - the spectrum analyzer already contains at its interior the processors necessary for carrying out the Fourier transform calculation, as well as the drivers necessary for transmitting the resulting data online by means of GSM connection. In several variants of the present invention, nevertheless, we propose an expansion of the reception capacity and of the computing capacity of a single spectrum analyzer. In particular, in order to be able to measure the quality of the signal simultaneously for multiple bands, it is proposed to use systems of multi-core processors adapted to allow the parallel calculation, and for even greater speeds it is proposed to directly integrate graphics cards (GPU) in the spectrum analyzer, with floating point computing capacities for algorithms such as the Fourier Transform mentioned several times above (or also FFT: Fast Fourier Transform) that are much greater than the processors of CISC (complex instruction set computer) type. If necessary, one of the variants also provides for the presence of a multiple number of antennas, in a manner such to be able to detect signals relative to different bands in a simplified and effective manner. The data produced by said spectrum analyzers contains all the information necessary for being able to view, on an application software, the quality of the signal in a specific geographic position. At this point, it would be necessary that a single operator with the instrument moves into a new position and carries out another measurement. This however, already stated, creates latencies. Therefore, the proposed solution consists of having a multiplicity of instruments which, when entrusted to different operators, carry out measurements simultaneously in different places. At this point, data arrives in the operations center that is relative to all the instruments operating in the field. The GPS coordinates sent by each of these will form a polygon on a map, within which we can reasonably state that the signal has a specific measured quality given the results of all the analyzers. It shall be assumed for the moment that there are no obstacles of large size between each pair of points on the map. Nevertheless, it could happen that, for a given frequency band, one of the analyzers, in a given position X, receives a high signal power, indicating that in that point it is not possible to transmit other data without creating interferences. The objective is then to redefine which modification can be made to the polygon in order to obtain an area which is free, or to define another frequency band that is free in that zone. In the same manner, even if at that point the frequency band is free, one may wish to move the measurement point in order to discover the border corresponding to the maximum area of the geographic zone characterized by having said free band. This type of aggregate information is visible to the operator who is situated in the operations center, and from the analyses that he/she views on a screen by means of a suitable graphical software application, he/she can give information and indications to the operators in the field to move in a given direction in order to carry out further measurements. By means of a communication of telephone or text type, this operation is any case quite easy and quick.

The present invention, nevertheless, in one variant wishes to extend itself beyond in solving the problem. By constructing the idea after assuming the use of particularly fast spectrum analyzers, as well as communication lines that are also high speed, a further passage is proposed. It is assumed that the spectrum analyzers are actuated and set initially by an operator who fixes them to his/her motor vehicle, and he/she starts driving. At regular time intervals of brief duration, such as for example every second or every 5 seconds, the instrument detects the position and carries out a measurement of the signal. In the meantime, the operator with the motor vehicle is moving. It is also assumed that the analyzer is set so as to detect multiple bands simultaneously, and that each operator seeks to visit, in a fairly ordered manner, all the points that can be reached by means of the vehicle in a given range of coordinates. For grounds of efficiency, the operators never follow a road that has already been covered by another operator and at the end of the journey a macro-area dictated by the sum of the areas covered by each operator will be automatically evaluated. The automatic evaluation in this case can resolve a problem of optimization by means of calculations that will be executed on the server that receives the data in the operations center: thus, will it be able to reply to the question: what is the maximum area perimeter within which, at each point, at least one frequency band is free?

With this free frequency, one could evaluate whether or not to request the activation of a new municipal plant: i.e., open a request procedure for a new broadcasting station. In practice, the various measurement points are detected, all the relative derived traces are examined, they are arranged on a single screen and in real time all the zones are underlined where free frequencies are present. If such conditions are verified, the motion for authorization for a new broadcasting station can be presented.

One can reply to this application in an approximate manner, but in any case, a good approximation given the multiplicity of measurements that are made possible in relatively brief times and scalable with the increase of the number of instruments and operators.

One variant extends the present invention to the third dimension. Indeed, up to now only the two-dimensional view has been considered up to now, considering the coordinates without accounting for the altitude at which the measurement is made. One of the ideated options consists of the use of radio-controlled flying means, e.g., drones, which incorporate or transport said spectrum analyzers and measure, also by means of atmospheric pressure and distance from the ground, the altitude at which a given measurement has been carried out, allowing the reformulation of the abovementioned question in three dimensions.

A final variant provides that if one wishes to analyze a new zone enclosed by other zones whose measurements have already been recently conducted, for the perimeter of this new zone the data will be used that was stored in the past in the servers of the operations center, without having to recalculate from scratch, and allowing the performance of only the measurements that are actually necessary.

In particular one can decide to execute the monitoring of the transmission performances of the radio broadcasting stations in a given territorial area, by actuating the screening of that locality and archiving it. In the end, there will be an archive of the spectra exactly as they appear on a given day, of the month and year. In fact, the compiling of an actual data bank is executed, comprising the historic screening data of a territory at the level of electromagnetic fields dedicated to FM broadcasting.

In a further embodiment of the general principle according to the present invention, the monitoring can be executed also on the performances of the same broadcasting station, by periodically evaluating the transmitted signal power therefore. For example, if by chance one sees a decrease of the signal power, one goes to check the historical record, and one examines what was the preceding configuration. For example, if one detects the signal with a power decreased by 20 db, some malfunction can be assumed (for example because an antenna is broken or trees have grown in front of the antenna).

The advantages offered by the present invention are evident in light of the description set forth up to now and will be even clearer due to the enclosed figures and to the relative detailed description.

### Description of the figures

The invention will be described hereinbelow in at least a preferred embodiment as a non-limiting example with the aid of the enclosed figures, in which:

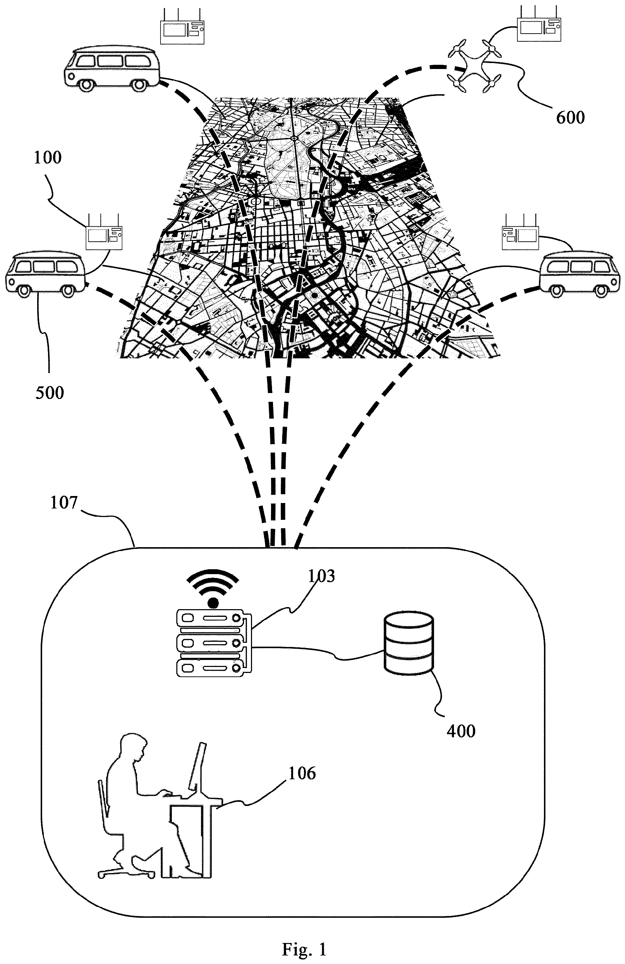

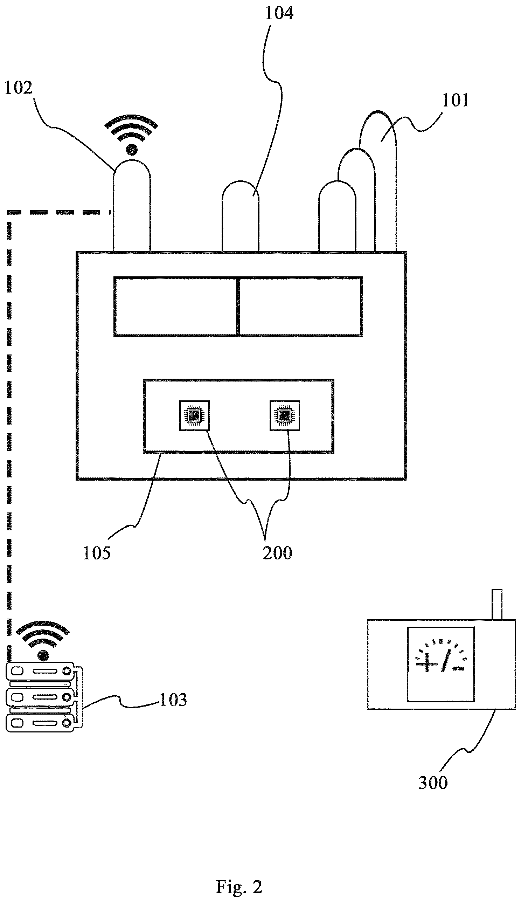

- FIGURE 1 shows, at high level, the architectural elements of the present invention. The operations center can be observed, which contains a server 103, a data base 400, a screen for displaying 106 the application. In the field, instead, there are the vehicles 500 which transport the spectrum analyzers 100 that are instead illustrated in detail in Fig. 2. Finally, one of the variants is illustrated in which a spectrum analyzer 100 is mounted on a remote-controlled drone 600.
- FIGURE 2 illustrates the essential components provided for the spectrum analyzer 100. In particular, the antennas are indicated relative to the measurement of the radio frequency signal 101, a representation of the antennas which serve for the GPS satellite communication 104 and for the GSM data communication 102. Finally, a pair of processors 200 are present. Connected to the device is a quality meter of the commercial digital radio signal 300 such as for example a Prolink Premium by Promax, which exploits the architecture of the present invention, nevertheless measuring a different value type more properly tied to the transmission of digital rather than analogue signals.

### Detailed description of the invention

The present invention will now be illustrated as a merely exemplifying and non-limiting or non-binding embodiment, with reference to the figures which illustrate several embodiments relative to the present inventive concept.

With reference to FIG. 1, we observe how a plurality of spectrum analyzers are used simultaneously in multiple places so as to circumscribe a polygon. Within this polygon, the frequency band will be measured in which it is possible to insert a new transmission without interfering with other signals. In particular a quick calculation allowed by the presence of multiple processors 200 and by a firmware that allows executing the analyses in a quick and parallel manner, possibly by also exploiting the computing capacities of integrated GPUs for the calculation of the FFT, enables the possibility to carry out a continuous measurement during the entire movement of the vehicle 500, automatically creating a map and a report of the bands with greater lack of signal on the screen of the operator in the operations center 107. With this application, the convenience lies in the fact that any measurement that comes to be executed - and for any user - by means of the platform dedicated for the acquisition and processing of the data is able to obtain an effective use of the spectrum analyzer 100.

At this point, it is desired to underline that the use of the data bank 400 is extremely advantageous. A few years after the first measurement, for example, it is assumed that the frequency of another FM radio that operates by means of the activation of a plant with modulated frequency is allocated that is too close to the frequency for which one wishes to protect the transmission without interferences. If one reports this with the authorities, the opposing party could sustain that the plant has been registered for years. However, it is easy to indicate that such radio station was never actually activated and that it does not have any service continuity. For such purpose, it is sufficient to review the measurements historically stored in the data bank. In conclusion, one has a data archive on which a signaling to the authority responsible for telecommunications is based, or for another action for dissuading the use of the frequency.

The examination is performed in an effective manner by means of the archived graphs and allows monitoring the occupation of the band and the possible interference introduced by the other antennas.

Finally, it is clear that modifications, additions or variations that are obvious for the man skilled in the art can be made to the invention described up to now, without departing from the protective scope that is provided by the enclosed claims.

## Claims

1. System for detecting free frequencies on geographic areas by means of spectrum analyzers **characterized in that** it comprises a plurality of spectrum analyzers (100) for radiofrequency signals adapted to define a geographic area of polygonal shape whose radio signal power in a given frequency range is to be measured, said analyzers being constructed so as to include at least:
A) an electronic computer (105) adapted to calculate, from the radio signal detected by an antenna (101), the spectral composition of the signal, thus defining according to a frequency decomposition the power relative to the fundamental frequencies;
B) a GPS localization system (104) adapted to detect the position of the instrument when the calculation of the characteristics of the detected signal is carried out;
C) a GSM connection (102) adapted to allow sending the information relating to the calculation of the characteristics of the signal detected or to the power of the frequencies for a given band, obtained from the spectral analysis, to a central electronic computer (103) located inside an operations center (107);
said central computer (103) being adapted to show on a screen (106) by means of a specific application, a polygon obtained from the sent positions superimposed on a map and therefore adapted to allow an operator at said operations center (107) to interpret the output of said application to instruct the other operators in the field about how to modify the position of the analyzers to better define the covered area.

2. System for detecting free frequencies on geographic areas using spectrum analyzers, according to the preceding claim 1, **characterized in that** it is adapted to simultaneously analyze a plurality of frequency bands, using redundant hardware including, by way of example, a plurality of antennas (101) and a plurality of calculation processors (200) for a parallel analysis of the signal relating to said plurality of frequency bands.

3. System for detecting free frequencies on geographic areas using spectrum analyzers, according to any one of the preceding claims 1 or 2, **characterized in that** the quality of the digital radio streaming is calculated by means of commercial meters (300), for example by calculating the signal-to-noise fraction and the fraction of incorrect bits in the digitized signal.

4. System for detecting free frequencies on geographic areas using spectrum analyzers, according to any one of the preceding claims, **characterized in that** said central electronic computer (103) exports all the data relating to the analysis carried out on a file stored on a durable memory (400), and is also adapted to access said memory during the calculations relating to subsequent analyses and measurements, relating to geographical areas adjacent to those of detections already carried out and stored, thus speeding up the calculation.

5. System for detecting free frequencies on geographic areas using spectrum analyzers, according to any one of the preceding claims, **characterized in that,** by exploiting a fast data connection between said computer (105) and said central computer (103) and a fast analysis using performing processors, the data produced by said radiofrequency signal analyzers (100) positioned on board a plurality of moving motor vehicles (500) are recorded, automatically returning the geographic polygon relating to the widest coverage given the journey made by said motor vehicles.

6. System for detecting free frequencies on geographic areas using spectrum analyzers, according to any one of the preceding claims, **characterized in that** said radio frequency signal analyzers (100) are implemented in hardware of limited weight and dimensions so that they can be transported on a plurality of remote-controlled drones (600) adapted to allow measurement of three-dimensional areas in the case of particular orographic situations.

7. System for detecting free frequencies on geographic areas using spectrum analyzers, according to any one of the preceding claims, **characterized in that** said radiofrequency signal analyzers (100) exploit parallel computing processors of the GPU type for a decomposition time of the high-speed frequencies.

8. Use of a system for detecting free frequencies on geographic areas using spectrum analyzers, according to any one of the preceding claims, in the detection of malfunctions of the transmitting antennas by exploiting the ability to detect the low power of signals within the frequency band under analysis.
